(19) Europäisches Patentamt

European Patent Office

Office européen des brevets

(11) Veröffentlichungsnummer: **0 264 470 B1**

# (12) EUROPÄISCHE PATENTSCHRIFT

(45) Veröffentlichungstag der Patentschrift: 06.03.91

(51) Int. Cl.5: **H03K 6/04, H03G 11/08**

(21) Anmeldenummer: 86114537.3

(22) Anmeldetag: 21.10.86

(54) **Verfahren zur digitalen Regelung der Flankensteilheit der Ausgangssignale von Leistungsverstärkern der für einen Computer bestimmten Halbleiterchips mit hochintegrierten Schaltungen.**

(43) Veröffentlichungstag der Anmeldung:
27.04.88 Patentblatt 88/17

(45) Bekanntmachung des Hinweises auf die Patenterteilung:
06.03.91 Patentblatt 91/10

(84) Benannte Vertragsstaaten:
**CH DE ES FR GB IT LI NL SE**

(73) Patentinhaber: **International Business Machines Corporation**
**Old Orchard Road**
**Armonk, N.Y. 10504(US)**

(72) Erfinder: **Ludwig, Thomas, Dipl.-Ing.**
**Rösslesmühlestrasse 8**
**W-7032 Sindelfingen(DE)**
Erfinder: **Schettler, Helmut, Dipl.-Ing.**
**Jägerstrasse 23**
**W-7405 Dettenhausen(DE)**
Erfinder: **Zuehlke, Rainer, Dr.-Ing.**
**Rainstrasse 3**
**W-7251 Leonberg 7(DE)**
Erfinder: **Wagner, Otto, Dipl.-Ing.**
**Buchenweg 36/1**
**W-7031 Altdorf(DE)**

(74) Vertreter: **Gaugel, Heinz, Dipl.-Ing.**
**IBM Deutschland GmbH Schönaicher Strasse 220**
**W-7030 Böblingen(DE)**

Beschreibung

Die Erfindung betrifft ein Verfahren und eine Schaltungsanordnung zur digitalen Regelung der Flankensteilheit der Ausgangssignale von Leistungsverstärkern der für einen Computer bestimmten Halbleiterchips mit hochintegrierten Schaltungen. Bei der parallelen Datenübertragung in Computern müssen mehrere Leistungsverstärker gleichzeitig ein- oder ausgeschaltet werden. Die beim Schaltvorgang in den Versorgungsleitungen auftretende Stromänderung ruft aufgrund der Induktivität L dieser Leitungen eine Störspannung $u_L$ hervor, deren Größe sich nach dem Induktionsgesetz zu $u_L = -L \, di/dt$ bestimmt. Je mehr Leistungsverstärker gleichzeitig schalten und je schneller sie das tun, d.h. je größer die Flankensteilheit ihrer AusgangsSignale ist, umso größer ist die unerwünschte Störspannung auf den Versorgungsleitungen. Dadurch können Schaltkreise auf dem selben Halbleiterchip in ihrer richtigen Funktionsweise gestört werden. Leistungsverstärker zu anderen Halbleiterchips, die in einem schaltzustand verharren, übertragen die induzierte Störspannung zu diesen Halbleiterchips, die dort als Datenänderung vom Empfängerschaltkreis erkannt werden können und zu Fehlfunktionen führen.

Um einen fehlerfreien Betrieb eines Computers zu gewährleisten, muß daher dafür gesorgt werden, daß die genannte Störspannung unterhalb der Schaltschwelle der Speicherglieder bleibt. Man hat sich deshalb in der Vergangenheit damit beholfen, die Leistungsverstärker, deren gleichzeitiges Schalten zwar erwünscht, aber aus Gründen der Störspannungserzeugung nicht durchführbar war, gruppenweise zusammenzufassen und die Gruppen zeitlich gestaffelt zu schalten.

Dadurch wird jedoch die Geschwindigkeit der Datenübertragung vermindert.

Der Erfindung liegt die Aufgabe zugrunde, ein gleichzeitiges Schalten einer erwünschten Anzahl von an einen Datenbus angeschlossenen Leistungsverstärkern zu ermöglichen, ohne daß die dabei entstehende Störspannung einen unzulässig hohen Wert annimmt. Die Erfindung, wie sie in den Ansprüchen gekennzeichnet ist, löst diese Aufgabe dadurch, daß sie ein Verfahren und eine Schaltungsanordnung zur digitalen Regelung der Flankensteilheit von Leistungsverstärkern angibt und einen für die Durchführung des Verfahrens geeigneten Leistungsverstärker.

Außer der schon erwähnten Beschleunigung der Datenübertragung durch das Vermeiden des zeitlich gestaffelten Schaltens gruppenweise zusammengefaßter Leistungsverstärker ermöglicht die Erfindung auch das Angleichen unterschiedlicher Flankensteilheiten solcher Leistungsverstärker, die sich auf verschiedenen Halbleiterchips befinden und deren unterschiedliche Flankensteilheiten durch Toleranzen des Herstellungsprozesses bedingt sind. Weiter lassen sich Auswirkungen auf die Flankensteilheit, die durch Temperaturänderungen und/oder Schwankungen der Versorgungsspannung verursacht sind, durch die Erfindung ausgleichen. Schließlich ermöglicht die Erfindung auch einen sichereren Testbetrieb, indem sie es gestattet, die beim Schalten der Leistungsverstärker infolge der großen Induktivität der Kontaktsonden auftretende höhere Störspannung durch Wahl einer geringeren Flankensteilheit unterhalb dem zulässigen Wertes zu halten.

Im folgenden wird die Erfindung in Verbindung mit den Zeichnungen näher erläutert, von denen zeigt:

Fig.1 das Blockschaltbild einer Schaltungsanordnung zur Durchführung des Verfahrens nach der Erfindung.

Fig.2 das vereinfachte Schaltbild eines Leistungsverstärkers, bei dem die Flankensteilheit seiner Ausgangssignale regelbar ist.

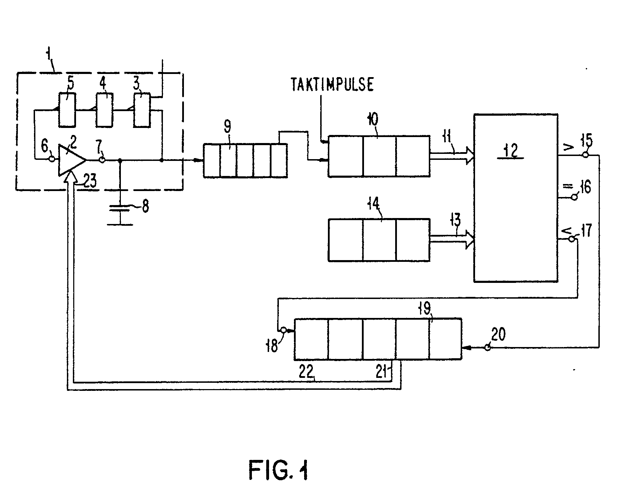

Im Blockschaltbild der Fig.1 umschließt die Strichlinie einen Ringoszillator 1, der einen der Leistungsverstärker 2 enthält, deren Flankensteilheit geregelt werden soll, und eine ungerade Anzahl von Znverterstufen 3, 4 und 5, die das Schwingen des Ringoszillators durch Rückführen des Ausgangssignales des Inverters 5 auf den Dateneingang 6 des Leistungsverstärkers 2 sicherstellen. Der Inverter 3 wird durch ein Nand-Glied realisiert, dessen zweitem Eingang ein Steuersignal zugeführt wird, das durch einen Pegelwechsel ein Auftrennen der Ringoszillatorschleife ermöglicht. Ein externer Kondensator 8 ist an den Ausgang 7 des Leistungsverstärkers 2 angeschlossen. Sein Kapazitätswert wird entsprechend der durchschnittlichen Lastkapazität der zu regelnden Leistungsverstärker gewählt und bestimmt die Frequenz des Ringoszillators 1 mit. Der Ausgang 7 des Leistungsverstärkers 2 ist mit dem Eingang eines ersten Zählers 9 verbunden, der die Impulse des Ringoszillators 1 zählt. Der erste Zähler 9 steuert bis zu seinem Uberlauf einen zweiten Zähler 10, dem bis zum Uberlauf des ersten Zählers 9 Taktimpulse als Zählimpulse zugeführt werden. Ihre Anzahl ist ein Maß für den Istwert der Flankensteilheit der zu regelnden Leistungsverstärker.

Der Inhalt des zweiten Zählers 10 wird den ersten Eingängen 11 einer Vergleichsschaltung 12 zugeführt, deren zweite Eingänge 13 an ein Register 14 angeschlossen sind, das den Sollwert der Flankensteilheit aufnimmt. Die Vergleichsschaltung 12 besitzt entsprechend den drei möglichen Vergleichsergebnissen kleiner, größer, gleich drei Ausgänge 15, 16 und 17. Der Ausgang 15 ist an den Links-Steuereingang 18 eines Links-Rechts-Schieberegisters 19 angeschlossen, während der Ausgang 17 mit dem Rechts-Steuereingang 20 des Schieberegisters verbunden ist. Dessen Parallelausgänge 21 sind über Leitungen 22 an die Steuereingänge 23 der Leistungsverstärker 2 angeschlossen, deren Flankensteilheit geregelt werden soll.

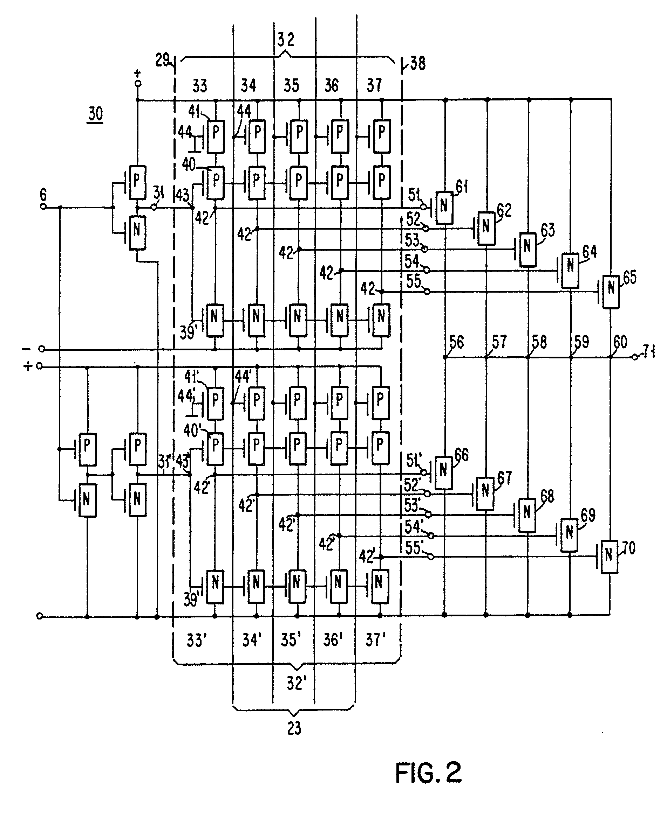

Ein vereinfachtes Schaltbild eines dieser Leistungsverstärker mit regelbarer Flankensteilheit der Ausgangssignale ist in Fig.2 wiedergegeben. Der Leistungsverstärker weist einen dreiteiligen Aufbau auf. Auf eine von der nachfolgenden Schaltung durch eine Strichlinie 29 getrennte Eingangsstufe 30 mit zwei komplementären Ausgängen 31 bzw. 31' folgt eine an jeweils einen dieser Ausgänge angeschlossene Gruppe 32 bzw. 32' von Vorstufen 33-37 bzw. 33'-37', die durch eine Strichlinie 38 von der nachfolgenden Schaltung getrennt sind. Die Vorstufen 33-37 bzw. 33'-37' sind hinsichtlich ihrer Schaltstrecken parallel geschaltet. Jede Vorstufe besteht aus der Serienschaltung dreier Transistoren 39, 40, 41 bzw. 39', 40', 41', von denen der erste 39 bzw. 39' vom einen und die beiden anderen, 40, 41 bzw. 40', 41' vom anderen Leitungstyp sind. Der Verbindungspunkt der beiden Transistoren entgegengesetzten Leitungstyps stellt den Ausgang 42 bzw. 42' der Vorstufe dar. Jede Vorstufe weist zwei Eingänge 43, 44 bzw. 43', 44' auf. Die ersten Eingänge 43 aller Vorstufen der einen Gruppe 32 sind an den ersten Ausgang 31 der Eingangsstufe 30, die der anderen Gruppe 32' an den anderen Ausgang 31' angeschlossen. Die zweiten Eingänge aller Vorstufen 33-37 bzw. 33'-37' sind bis auf eine Vorstufe in jeder Gruppe, deren zweiter Eingang zur Gewährleistung der Funktionsfähigkeit der Schaltung an das Bezugspotential angeschlossen ist, an jeweils einen anderen Parallelausgang des Links-Rechts-Schieberegisters 19 angeschlossen. Jeder der Ausgänge 42 bzw. 42' der Vorstufen 33-37 bzw. 33'-37' ist mit einem anderen der Eingänge 51-55 bzw. 51'-55' der im folgenden beschriebenen Endstufe 50 des Leistungsverstärkers 2 verbunden. Diese Endstufe, die als Gegentakt-Endstufe arbeitet, besteht aus einer Gruppe 50 von Gegentaktverstärkern 56-60. Sowohl die Transistoren 61-65 zur Erzeugung der ansteigenden Flanke des Ausgangssignals als auch die Transistoren 66 bis 70 zur Erzeugung der abfallenden Flanke sind hinsichtlich ihrer Schaltstrecken parallel geschaltet. Die Verbindungspunkte aller Transistoren 61-65 zum Erzeugen der ansteigenden Flanke des Ausgangssignals sind mit den Transistoren 66-70 zur Erzeugung der abfallenden Flanke sind untereinander verbunden und bilden den Ausgang 71 des Leistungsverstärkers.

Im folgenden wird die Wirkungsweise der Schaltungsanordnung zur Durchführung des Verfahrens nach der Erfindung erläutert.

Der Sollwert der Flankensteilheit wird dem Sollwert-Register 14 zugeführt. Der Istwert wird durch die Anzahl von Taktimpulsen repräsentiert, die während eines Meßintervalles, dessen Dauer vom Istwert der Flankensteilheit abhängig ist, dem Zähler 10 zugeführt werden. Das Meßintervall wird dadurch erzeugt, daß die Impulse des Ringoszillators 1, der einen der Leistungsverstärker 2 enthält, deren Flankensteilheit geregelt werden soll, dem Zähler 9 bis zu dessen Überlauf zugeführt werden. Das dadurch bestimmte Intervall ist umso länger, je geringer die Flankensteilheit des im Ringoszillator verwendeten Leistungsverstärkers 2 ist und umgekehrt. Nach dem Überlauf des Zählers 9 wird die Ringoszillatorschleife mit Hilfe des Nand-Gliedes 3 unterbrochen. Sodann wird der Zählerstand des Zählers 10, der den Istwert der Flankensteilheit repräsentiert, mit dem im Sollwert-Register 14 enthaltenen Wert in der Vergleichsschaltung 12 verglichen. Das Vergleichsergebnis wird dem Links-Rechts-Schieberegister 19 zugeführt. Zeigt das Vergleichsergebnis an, daß der Istwert der Flankensteilheit größer als der Sollwert ist, erscheint am Ausgang 15 der Vergleichsschaltung 12 ein Signal, durch das der Schieberegisterinhalt, der zu Beginn des Regelungsvorganges aus lauter gleichen Binärwerten, beispielsweise aus lauter Einsen, besteht, nach links geschoben wird und eine Eins nachrücken läßt. Dies bedeutet, daß eine der mit den Steuereingängen 23 des Leistungsverstärkers 2 verbundenen Ausgangsleitungen 22 des Schieberegisters 19 ein Potential erhält, durch das eine der Vorstufen 33-37 bzw. 33'-37' des Leistungsverstärkers 2 gesperrt wird. Dadurch wird auch die zugeordnete Endstufe des Leistungsverstärkers 2 gesperrt. Sie ist damit nicht mehr stromdurchflossen, wodurch die Flankensteilheit des Ausgangssignals verringert wird. Anschließend wird die Ringoszillatorschleife über das Nand-Glied 3 wieder geschlossen und der neue Istwert der Flankensteilheit wieder mit dem Sollwert verglichen. Ergibt der Vergleich, daß der Istwert kleiner als der Sollwert ist, liefert die Vergleichsschaltung 12 am Ausgang 17 ein Signal, durch das der bisherige Registerinhalt nach rechts geschoben wird und eine Null nachrückt. Damit erhält die Ausgangsleitung einer weiteren Schieberegisterstufe ein solches Potential, daß eine der beiden an sie angeschlossenen Vorstufen leitend wird. Damit wird auch die zugeordnete Endstufe zusätzlich stromführend, was zu einer Vergrößerung der Flankensteilheit des Ausgangssignals führt.

Die beschriebenen Schritte werden solange wiederholt, bis die Gleichheit von Soll- und Istwert erreicht ist. In diesem Fall bleibt der Inhalt des Schieberegisters erhalten.

Außer in der früher beschriebenen Weise kann das Erfassen des Istwertes der Flankensteilheit auch derart erfolgen, daß die Dauer des Meßintervalles konstant gehalten wird und beispielsweise mehrere Taktimpulszyklen umfaßt. Während dieser Zeit wird die Anzahl der Ringoszillatorimpulse gezählt. Durch Abfrage des Zählerstandes erhält man ein der Flankensteilheit des im Ringoszillator enthaltenen Leistungsverstärkers proportionales Zählergebnis. Es ist umso größer, je größer die Flankensteilheit ist.

Ändert sich im Laufe des Betriebes der Datenverarbeitungsanlage die Betriebstemperatur oder schwankt die Versorgungsspannung, was sich als Änderung der Flankensteilheit äußert, so erfolgt eine Nachregelung, da der Vergleich von Ist- und Sollwert laufend durchgeführt wird.

## Ansprüche

1. Verfahren zur digitalen Regelung der Flankensteilheit der Ausgangssignale von Leistungsverstärkern der für einen Computer bestimmten Halbleiterchips mit hochintegrierten Schaltungen, gekennzeichnet durch folgende Verfahrensschritte;
   a) Erfassen des Istwertes der Flankensteilheit über die Anzahl von Taktimpulsen, die einem ersten Zähler (10) während eines Meßintervalles zugeführt werden, dessen Dauer von der Flankensteilheit abhängig ist,
   b) Vergleichen des durch den Zählerstand repräsentierten Istwertes mit dem in einem Sollwert-Register (14) gespeicherten Sollwert in einer Vergleichsschaltung (12),
   c) Zuführen des Vergleichsergebnisses zu einem Links-Rechts-Schieberegister (19), von jedem von dessen Parallelausgängen (21) ein Steuersignal geliefert wird, das eine jeweils zugeordnete Endstufe (56-60) der Leistungsverstärker (2) entweder aktiviert oder sperrt, wobei die Endstufen (56-60) parallelgeschaltet sind und die Anzahl der aktivierten Endstufen dem Sollwert der Flankensteilheit proportional ist.

2. Verfahren nach Anspruch 1, dadurch gekennzeichnet, daß die Dauer des Meßintervalles zum Erfassen des Istwertes der Flankensteilheit dieser umgekehrt proportional ist.

3. Verfahren nach Anspruch 2, dadurch gekennzeichnet, daß das Meßintervall gebildet wird durch Zuführen der Impulse eines Ringoszillators (1), der einen der Leistungsverstärker (2) enthält, zu einem weiteren Zähler (9) bis zu dessen Überlauf.

4. Verfahren nach Anspruch 3, dadurch gekennzeichnet, daß das fest vorgegebene Meßintervall ein ganzzahliges Vielfaches des Taktintervalles beträgt und erzeugt wird durch Zuführen der Taktimpulse zu einem zweiten Zähler bis zu einem vorgegebenen Zählerstand.

5. Schaltungsanordnung zur Durchführung des Verfahrens nach einem der Ansprüche 3 oder 4, dadurch gekennzeichnet, daß an den Ausgang des im Ringoszillator (1) enthaltenen Leistungsverstärkers (2) ein Kondensator (8) angeschlossen ist, dessen Kapazitätswert der durchschnittlichen Ausgangslast der übrigen Leistungsverstärker entspricht.

6. Schaltungsanordnung zur Durchführung des Verfahrens nach den Ansprüchen 1 bis 4 nach Anspruch 5 dadurch gekennzeichnet, daß die Leistungsverstärker (2) als Gegentaktverstärker aufgebaut sind und folgenden Aufbau aufweisen:
   a) Eine Eingansstufe (30) mit zwei Ausgängen (31, 31') für komplementäre Binärsignale,
   b) eine an jeden dieser Ausgänge angeschlossene Gruppe (32, 32') von Vorstufen (33-37 bzw. 33'-37'), die hinsichtlich ihrer Schaltstrecken parallel geschaltet sind und deren jede einen Ausgang (42, 42') und zwei Eingänge (43, 44 bzw. 43', 44') besitzt, von denen der zweite (44, 44') jeweils an einen der Parallelausgänge (21) des Links-RechtsSchieberegisters (13) angeschlossen ist,
   c) eine Gegentakt-Endstufe (50), bei der zur Erzeugung des sollwertes sowohl als auch der abfallenden Flanke des Ausgangssignales mehrere hinsichtlich ihrer Schaltstrecken parallel geschaltete Transistoren (61-65 bzw. 66-70) vorgesehen sind, deren Steuerelektroden jeweils an den Ausgang (42, 42') einer jedem Endstufentransistors zugeordneten Vorstufe (33-37, 33'-37') angeschlossen sind.

7. Schaltungsanordnung nach Anspruch 6, dadurch gekennzeichnet, daß jede Vorstufe aus der Serienschaltung dreier Transistoren (39, 40, 41, bzw. 39', 40', 41') besteht, von denen der erste (39 bzw. 39') dem einen Leitungstyp und die beiden anderen (40, 41 bzw. 40', 41') dem anderen Leitungstyp angehören, daß der Verbindungspunkt der beiden Transistoren unterschiedlichen Leitungstyps den Ausgang (42 bzw. 42') der Vorstufe bildet, daß die Steuerelektroden dieser Transistoren mit dem gleichen Ausgang (32 bzw. 32') der Eingangsstufe (30) verbunden sind und daß die Steuerelektroden der dritten Transistoren einer Gruppe bis auf eine, die an ein Bezugspotential angeschlossen ist, jeweils mit einem der Parallelausgänge (2l) des Links-Rechts-Schieberegisters (14) verbunden sind.

8. Schaltungsanordnung nach Anspruch 6, dadurch gekennzeichnet, daß die Eingangsstufe (30) und die Vorstufen (30-37 bzw. 30'-37') aus komplementären und die Gegentakt-Endstufe (50) aus Transistoren eines Leitungstyps aufgebaut sind.

9. Schaltungsanordnung nach den Ansprüchen 6 bis 8, dadurch gekennzeichnet, daß sie aus FeldeffektTransistoren aufgebaut ist.

## Claims

1. Method for the digital slope control of the output signals of power amplifiers of semiconductor chips with VLSI circuits for a computer, characterized by the following process steps:
   a) representing the actual slope value via the number of clock pulses applied to a first counter (10) during a measuring interval whose duration depends on the slope,
   b) comparing in a comparator circuit (12) the actual value represented by the count with the nominal value stored in a nominal value register (14),
   c) applying the result of the comparison to a left/right-shift register (19) from each of whose parallel outputs (21) one control signal is provided which either activates or deactivates a respectively associated output stage (56-60) of the power amplifiers (2), the output stages (56-60) being arranged in parallel and the number of activated output stages being proportional to the nominal value of the edge slope.

2. Method as claimed in claim 1, characterized in that the duration of the measuring interval for representing the actual slope value in inversely proportional thereto.

3. Method as claimed in claim 2, characterized in that the measuring interval is formed by applying the pulses of a ring oscillator (1) comprising one of the power amplifiers (2) to another counter (9) until overflow of the latter.

4. Method as claimed in claim 3, characterized in that the predetermined measuring interval represents an integer multiple of the clock interval, and that it is generated by applying the clock pulses to a second counter up to a predetermined count.

5. Circuit arrangement for carrying out the method as disclosed in any one of claims 3 or 4, characterized in that connected to the output of the power amplifier (2) comprised in the ring oscillator (1) a capacitor (8) is provided whose capacity corresponds to the average output load of the other power amplifiers.

6. Circuit arrangement for carrying out the method as claimed in any one of claims 1 to 4 or as claimed in claim 5, characterized in that the power amplifiers (2) are designed as push-pull amplifiers and have the following structure:
   a) an input stage (30) with two outputs (31, 31') for complementary binary signals,
   b) a group (32, 32') of pre-stages (33 to 37 or 33' to 37', respectively), connected to each one of these outputs, which pre-stages are arranged in parallel with respect to their switching paths and respectively have one output (42, 42') and two inputs (43, 44 or 43', 44', respectively), of which the second (44, 44') is respectively connected to one of the parallel outputs (21) of the left/-right-shift register (13),
   c) a push-pull output stage (50) where for producing the nominal value of the rising as well as the trailing slope of the output signal several transistors (61 to 65 or 66 to 70, respectively), arranged in parallel with respect to their switching paths are provided whose control electrodes are respectively connected to the output (42, 42') of a pre-stage (33 to 37, 33' to 37') associated to each output stage transistor.

7. Circuit arrangement as claimed in claim 6, characterized in that each pre-stage consists of the series arrangement of three transistors (39, 40, 41 or 39', 40' 41', respectively), of which the first (39 or 39') is of the one conductivity type and the two others (40, 41 or 40', 41') of the other conductivity type, that the point of connection of the two transistors of different conductivity represent the output (42 or 42') of the pre-stage, that the control electrodes of these transistors are connected to the same output (32 or 32') of the input stage (30), and that the control electrodes of the third transistors of a group, with the exception of one that is connected to a reference potential, are respectively connected to one of the parallel outputs (21) of the left/right-shift register (14).

8. Circuit arrangement as claimed in claim 6, characterized in that the input stage (30) and the pre-stages (33 to 37 or 33' to 37', respectively) consist of complementary transistors, and the push-pull output stage (50) of transistors of one conducively type.

9. Circuit arrangement as claimed in any one of claims 6 to 8, characterized in that it is composed of field effect transistors.

**Revendications**

1. Procédé de réglage numérique de la pente des flancs des signaux de sortie d'amplificateurs de puissance des microplaquettes à semiconducteurs, destinées à un ordinateur et comportant des circuits à haute densité d'intégration, caractérisé par les étapes opératoires suivantes:
   a) détection de la valeur réelle de la pente des flancs au moyen du nombre d'impulsions de cadence, qui sont envoyées à un premier compteur (10) pendant un intervalle de mesure, dont la durée dépend de la pente des flancs,
   b) comparaison de la valeur réelle, représentée par l'état de comptage, à la valeur de consigne mémorisée dans un registre (14) de la valeur de consigne, dans un circuit comparateur (12),
   c) envoi du résultat de la comparaison à un registre à décalage gauche-droite (19), dont chacune des sorties parallèles (21) délivre un signal de commande qui active ou bloque un étage final respectivement associé (56-60) des amplificateurs de puissance (2), les étages finals (56-60) étant branchés en parallèle et le nombre des étages finals activés étant proportionnel à la valeur de consigne de la pente des flancs.

2. Procédé selon la revendication 1, caractérisé en ce que la durée de l'intervalle de mesure pour la détection de la valeur réelle de la pente des flancs est inversement proportionnelle à cette pente.

3. Procédé selon la revendication 2, caractérisé en ce que l'intervalle de mesure est formé par envoi des impulsions d'un oscillateur en anneau (1), qui contient l'un des amplificateurs de puissance (2), à un autre compteur (9), jusqu'au dépassement de la capacité de ce dernier.

4. Procédé selon la revendication 3, caractérisé en ce que l'intervalle de mesure prédéterminé de façon fixe est égal à un multiple entier de l'intervalle de cadence et est formé grâce à l'envoi des impulsions de cadence à un autre compteur jusqu'à l'obtention d'un état de comptage prédéterminé.

5. Montage pour la mise en oeuvre du procédé selon l'une des revendications 3 ou 4, caractérisé en ce qu'à la sortie de l'amplificateur de puissance (2) contenu dans l'oscillateur en anneau (1) est raccordé un condensateur (8), dont la capacité correspond à la charge de sortie moyenne des autres amplificateurs de puissance.

6. Montage pour la mise en oeuvre du procédé selon les revendications 1 à 4 ou selon la revendication 5, caractérisé en ce que les amplificateurs de puissance (2) sont réalisés sous la forme d'amplificateurs symétriques et possèdent la constitution suivante:
   a) un étage d'entrée (30) comportant deux sorties (31,31') pour des signaux binaires complémentaires,
   b) un groupe (32,32'), raccordé à chacune de ces sorties, d'étages amont (33,37 ou 33',37'), dont les sections de commutation sont branchées en parallèle et dont chacun possède une sortie (42,42') et deux entrées (43,44 ou 43',44'), parmi lesquelles la seconde entrée (44,44') est raccordée respectivement à l'une des sorties en parallèle (21) du registre à décalage gauche-droite (13),
   c) un étage final symétrique (50), dans lequel, pour la production de la valeur de consigne aussi bien du flanc montant que du flanc retombant du signal de sortie, il est prévu plusieurs transistors (61-65 ou 66-70), dont les sections de commutation sont branchées en parallèle et dont les électrodes de commande sont raccordées respectivement à la sortie (42,42') d'un étage amont (33-37,33'-37') associé à chaque transistor de l'étage final.

7. Montage selon la revendication 6, caractérisé en ce que chaque étage amont est constitué par le montage série de trois transistors (39,40,41 ou 39',40',41'), dont le premier (39 ou 39') possède un type de conductivité et dont les deux autres (40,41 ou 40',41') possèdent l'autre type de conductivité, que le point de jonction des deux transistors possédant des types de conduction différents forme la sortie (42 ou 42') de l'étage amont, que les électrodes de commande de ces transistors sont raccordées à la même sortie (32 ou 32') de l'étage d'entrée (30) et que les électrodes de commande des troisièmes transistors d'un groupe sont raccordées, hormis l'une d'elles qui est raccordée à un potentiel de référence, respectivement à l'une des sorties en parallèle (21) du registre à décalage gauche-droite (14).

8. Montage selon la revendication 6, caractérisé en ce que l'étage d'entrée (3) et les étages amont (30-37 ou 30'-37') sont constitués par des transistors complémentaires possédant un type de conductivité et que l'étage final symétrique (50) est constitué par des transistors possédant un type de conductivité.

9. Montage selon les revendications 6 à 8, caractérisé en ce qu'il est constitué par des transistors à effet de champ.

TAKTIMPULSE

FIG. 1

FIG. 2